# EUROPEAN PATENT SPECIFICATION

(11) **EP 1 474 697 B1**
(45) Date of publication and mention of the grant of the patent: **04.07.2007**
(21) Application number: 03739560.5
(22) Date of filing: 11.02.2003
(51) Int. Cl.: G01R 27/26, G01N 27/22, G06K 9/00, C12Q 1/68

(54) **CAPACITANCE SENSORS WITH ASYNCHRONOUS RING OSCILLATOR CIRCUIT AND CAPACITANCE SENSING METHOD**
KAPAZITÄTSSENSOREN MIT ASYNCHRONER RINGOSZILLATORSCHALTUNG UND VERFAHREN ZUR KAPAZITÄTSMESSUNG
CAPTEURS CAPACITIFS AVEC UN CIRCUIT D'OSCILLATEUR A ANNEAU ASYNCHRONE ET PROCEDE DE DETECTION DE CAPACITE

(30) Priority: 12.02.2002 GB 0203283
(43) Date of publication of application: 10.11.2004
(73) Proprietor: SEIKO EPSON CORPORATION, Tokyo 163 (JP); CAMBRIDGE UNIVERSITY TECHNICAL SERVICES LIMITED, Cambridge CB2 1TS (GB)
(72) Inventor: ISLAM, Mujahid c/o Epson Cambridge Laboratory, Cambridge CB4 4FF (GB); MOORE, Simon, Cambridge CB2 1SB (GB)
(74) Representative: Cloughley, Peter Andrew
(86) International application number: PCT/GB2003/000602
(87) International publication number: WO 2003/069360

(56) References cited:
- EP-A- 0 908 725
- US-A- 5 114 674
- US-A- 5 652 758
- US-A- 5 777 482
- US-A- 5 978 496
- US-A- 6 069 514
- US-A- 6 108 438
- TARTAGNI M ET AL: "A FINGERPRINT SENSOR BASED ON THE FEEDBACK CAPACITIVE SENSING SCHEME" IEEE JOURNAL OF SOLID-STATE CIRCUITS, IEEE INC. NEW YORK, US, vol. 33, no. 1, 1998, pages 133-142, XP000766627 ISSN: 0018-9200
- MOLNAR C E ET AL: "TWO FIFO RING PERFORMANCE EXPERIMENTS" PROCEEDINGS OF THE IEEE, IEEE. NEW YORK, US, vol. 87, no. 2, February 1999 (1999-02), pages 297-307, XP000889372 ISSN: 0018-9219

## Description

The present invention relates to capacitance sensors and in particular to capacitance sensors that can be used as biosensors, such as sensors used for DNA identification or fingerprint recognition. The present invention also relates to a method for capacitance sensing.

Capacitance sensors are in widespread use and it is known that certain capacitance sensors may be used in biosensing applications, such as in the identification of DNA, or for fingerprint recognition. Such sensors are known from EP-A-0 908 725, US-A-5,114,674 and US-A-6,108,438. However, there is an increasing need for relatively inexpensive, reliable and relatively disposable capacitance sensors for use as biosensors, particularly with the increasing need to carry out DNA identification. For DNA identification, an extremely large number of DNA sequences need to be investigated in order to determine whether or not a particular DNA sequence is present in a sample under investigation.

It is known that an electrode can be preconditioned with a particular DNA strand and when DNA in solution is placed into contact with the preconditioned electrode and there is a match between a DNA strand present in the solution and the DNA strand preconditioned onto the electrode, a very small change in capacitance occurs between the preconditioned electrode and another co-operating electrode arranged in close proximity to the preconditioned electrode. If a very large array of such electrodes are used, the DNA can be identified in a reasonable period of time because a number of strand comparisons can be carried out simultaneously. DNA can therefore be identified by measuring the change in capacitance which occurs when there is a match between DNA strands. However, in view of the large number of DNA strands which must be compared with the sample under test, it is stressed that not only must a very large number of sensors be used, but also these sensors must operate reliably to obtain meaningful results .

Many forms of chemical sensors, such as biosensors, have been proposed. One type of multi-biosensor comprises a pH sensor in the form of an array of four Ion Sensitive Field Effect Transistors (ISFET's) in combination with four Metal Oxide Silicon Field Effect Transistors (MOSFET's) acting as source follower circuits. However, in order to provide sufficient isolation between the ISFET's, the proposed array is relatively bulky in size. Furthermore, an IFSET is a form of transistor and considerable problems arise in electrically isolating such devices from a solution being tested. To alleviate the problems of isolation, the ISFET's and MOSFET's have been proposed to be fabricated on a silicon layer in the form of a number of discrete sites supported on a sapphire substrate. Sapphire is used as the substrate material because of its excellent electrical isolation properties. A protectional membrane is then formed over the gate surfaces of the ISFET's, followed by membranes respectively sensitive to the compounds to be tested. The individual sensors so produced function as pH sensors and may be used to detect urea, glucose and potassium. However, as mentioned above, the sensor array is of relatively large size, measuring approximately 2mm in width and 6mm in length for only a four sensor array. Furthermore, sapphire substrates can only be used to fabricate arrays to a finite size and it is well known that the concerns relating to the fabrication of arrays using silicon increase significantly with increase of array size. Additionally, the silicon and, in particular, the sapphire substrate materials are relatively expensive and therefore chemical sensors of the above type are extremely costly to fabricate. This cost aspect is particularly burdensome when considering that many types of such sensors can only be used once before disposal. Hence, such sensors are not, in practice, suitable for DNA identification.

More recently, sub-micron CMOS technology has been proposed for the fabrication of a biosensor array for DNA analysis. This technology has enabled an array of up to about 1000 sensor cells to be fabricated on a substrate having a size in the order of a few millimetres square. However, as the CMOS devices are fabricated on a silicon substrate, which can only be grown to a finite size, the proposed array has a high packing density.

To isolate the active CMOS devices from the wet operating environment, a specific integrated reaction test chamber is provided in the form of a cavity arranged between two superimposed and hermetically sealed printed circuits. The DNA material to be analysed is separated into its two strands by heating and, using a biochemical process, the strands are labelled with a fluorescent molecule. An analyte containing the DNA strands is then placed in contact with the semiconductor chip. If a DNA strand has a sequence matching that of a target arranged on an electrode of the sensor, hybridisation occurs which results in a physical localisation of the DNA sample onto the appropriate electrode of the chip. The chip is then rinsed and the sensor is read with a CCD camera. As the DNA strands have been labelled with a fluorescent molecule, relative brightness on the electrodes of the device indicates where bonding has occurred. Key issues in the applicability of such devices are recognised as materials compatibility, manufacturing and packaging in order to reliably deliver a wet-chip concept. These requirements can be compromised by the need to achieve a high packaging density on the silicon substrate material. Also, as will be apparent from the above description, such biosensors are relatively expensive to manufacture.

There are also concerns associated with the performance of silicon wafer devices when used to sense certain substances which exhibit a capacitive effect, such as that of matching DNA sequences referred to above. MOSFET's typically comprise a relatively thin layer of silicon dioxide (SiO₂ supported on a doped silicon substrate. The SiO₂ layer has inherent capacitance which is inversely proportional to the thickness of the layer. If the SiO₂ layer is fabricated to a typical thickness of about 100nm, there is significant loss of capacitive signal from the device and this is due to the inherent capacitance of the SiO₂ layer. If the SiO₂ layer is fabricated as a very thin layer to improve signal output, the devices become very unstable in use. These design conflicts can be alleviated if the sensing electrode is made very small. However, the sensing electrode must be fabricated to a size which is practical in use as it needs to receive the substance being identified. In practice, therefore the MOSFET gate area must be made relatively large but this gives rise to the basic fabrication concern regarding the use of silicon transistors for chemical sensors in that the provision of relatively large gate areas significantly reduces the packing density of the transistors which can be accommodated on the finite size silicon substrates, which in turn reduces the number of sensor cells that can be accommodated in the sensor array.

Thin film transistors (TFT's) are relatively inexpensive to manufacture as relatively cheap non-silicon materials such as soda glass or plastic can be used as a substrate. The use of a plastics substrate can provide additional benefits as it is a relatively disposable material in comparison to silicon. Furthermore, TFT's can be readily fabricated as very large area arrays and such technology has already found widespread application in industry, such as for example, in the manufacture of active matrix addressing schemes for liquid crystal display devices. The manufacturing processes are therefore well proven and a high yield of operable devices can reliably be obtained at relatively low costs, especially in comparison to silicon substrate devices. These advantages are further enhanced when considering that arrays many times larger than those available from silicon substrates can also be reliably fabricated, which in turn means that the number of sensing cells in the array can also be made very large, enabling a very large number of simultaneous tests to be carried out.

For chemical or biosensors in particular, the ability of TFT's to be readily fabricated as large area arrays at relatively low cost presents significant advantages in comparison to the conventionally used silicon devices as the need to achieve a very high packing density is not a dominant factor in device design. Hence, the area associated with each sensor cell of an array which receives the sample to be identified can, if necessary, be displaced from the active semiconductor components, alleviating the isolation concerns which exist with the current silicon substrate devices. Furthermore, the sensing areas for receiving a sample to be identified, which may be in the form of electrodes for a DNA sensor, can be made relatively large in size, enlarging the sensing area and enhancing device performance. Additionally, the use of enlarged sensing areas can provide a further benefit in that the packing density of the TFT's can be reduced from that found in many current practical applications where these devices are used, providing increased yields of fully functional devices from the existing well proven fabrication processes.

TFT's are known to exhibit lower mobility than silicon substrate transistors and, when fabricated as a large array of transistor devices, which would be of particular benefit for a biosensor, TFT's can exhibit variations in transfer characteristic between the transistors in the array. These variations can become more pronounced as the array size is increased and for DNA biosensors in particular, where typically a very large number of samples need to be analysed to identify a sample, a large area array is of very significant benefit in reducing the time required to analyse samples and therefore identify a particular DNA.

On the other side FIFO (first-in-first out)- asynchronous ring circuits are known from US-A-6,069,514 and US-A-5,777,482.

Hence, a biosensor in which the potential drawbacks associated with the variability in TFT performance can be overcome, enabling such devices to be readily and reliably used as the active devices for a chemical sensor in the form of a large array of sensor cells, is considered to be particularly advantageous and beneficial.

The present invention seeks to provide therefore an improved form of capacitance sensor, and in particular, an improved form of capacitance sensor for use as a biosensor which can be fabricated using TFTs and which can compensate for the variability in the operational characteristics known to exist with such devices.

According to a first aspect of the present invention there is provided a capacitance sensor comprising a plurality of circuit elements arranged as an asynchronous ring oscillator circuit and an electrode coupled to a node between two of the circuit elements.

Preferably, the circuit elements comprise delay circuits and inverter circuits coupled so as to provide first in first out (FIFO) circuit elements.

According to a second aspect of the present invention there is provided a DNA sensor or a fingerprint sensor including a capacitance sensor according to the first aspect of the present invention.

According to a third aspect of the present invention there is provided a capacitance sensing method comprising providing a sensor including a plurality of circuit elements arranged as an asynchronous ring oscillator circuit and sensing capacitance at an electrode coupled to a node between two of the circuit elements by sensing a change in frequency of oscillation of the asynchronous ring oscillator circuit.

Advantageously, the method comprises providing a plurality of delay elements and inverter circuits coupled to comprise FIFO circuit elements.

Preferably, the capacitive sensing method comprises a biosensing method including depositing a DNA sample onto the electrode to effect DNA identification or a human finger tip onto the electrode to effect fingerprint recognition.

Embodiments of the present invention will now be described by way of further example only and with reference to the accompanying drawings, in which:-
Figure 1 shows schematically a FIFO element;
Figure 2 shows schematically a plurality of the elements illustrated in Figure 1 coupled in series to provide a FIFO circuit;
Figure 3 shows waveform diagrams for the circuit illustrated in figure 2;
Figure 4 shows schematically a capacitance sensor in accordance with a first embodiment of the present invention;
Figure 5 shows schematically a capacitance sensor in accordance with a second embodiment of the present invention.
Figure 6 shows a capacitance sensor in accordance with a third embodiment of the present invention; and
Figure 7 shows a capacitance sensor arranged as an array of capacitance sensors and including a switching circuit to selectively couple electrodes to the sensors.

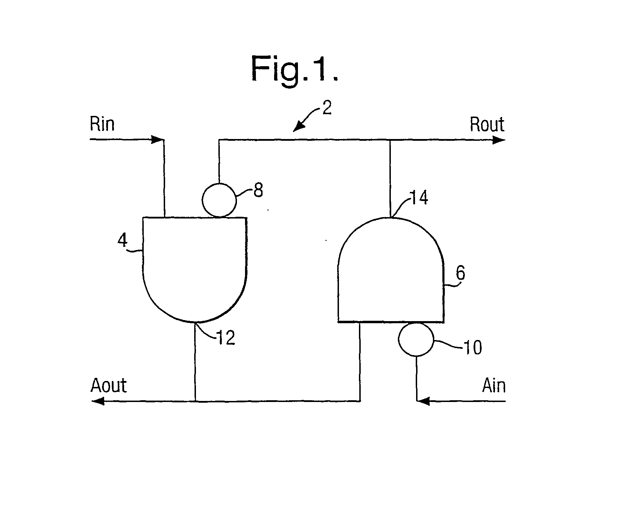

Figure 1 shows a "first in first out" (FIFO) element 2. The FIFO element 2 comprises two delay circuits 4 and 6, (often referred to in this art as Muller C-elements) each having two inputs, one output, and a respective inverter circuit 8, 10 coupled to one input. The output 12 of delay circuit 4 is coupled to an "acknowledge out" terminal Aout and one of the inputs (the non-inverting input) of delay circuit 6. The output 14 of delay circuit 6 is coupled via the inverter 8 to the second input of delay circuit 4 (the inverting input) and a "request out" terminal Rout. The second input of delay circuit 4 (the non-inverting input) is connected to a "request in" terminal Rin and the second input of delay circuit 6 (the inverting input) is connected to an "acknowledge in" terminal Ain.

In operation, the FIFO element 2 is arranged to receive an input data signal, such as a logic 1, on the request input Rin. This data signal is conveyed through delay circuits 4 and 6 to appear at the request output terminal Rout a predetermined time after input to the request input terminal Rin, the predetermined time being set by the combined delays of delay circuits 4 and 6. The logic 1 data signal conveyed to the request output terminal 1 Rout is also conveyed to the inverter 8. Hence, a logic ZERO appears at the input to delay element 4 coupled to inverter 8 and this logic ZERO is then conveyed, at a time determined by the delays of delay circuits 4 and 6, to the request output terminal Rout. The FIFO element acts therefore as a form of linear buffer with a memory.

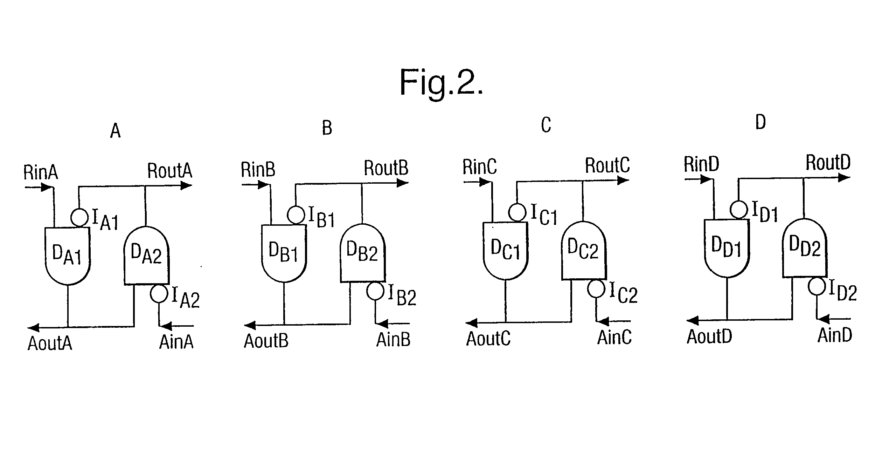

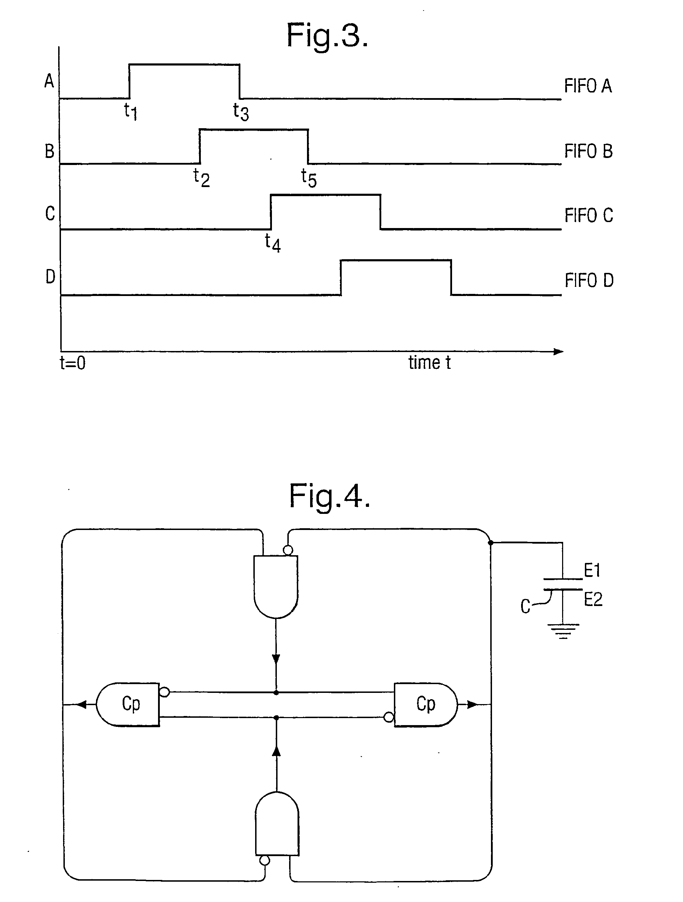

Figure 2 shows four FIFO elements A, B, C and D effectively connected in series to provide a FIFO circuit and the operation of the FIFO elements will be described with reference to this figure and also to figure 3, which shows waveform diagrams illustrating the switching of the FIFO elements A, B, C, D. Such a FIFO circuit is also referred to in this art as a micropipeline.

Each of the FIFO elements A, B, C, D has respective "request" and "acknowledge" input and output terminals, similar to those shown for the FIFO element 2 illustrated in figure 1. In the following description it is assumed that all outputs of the FIFO elements are logic ZERO at startup and that a logic 1 data signal appears on request input RiA and, therefore, on input in1 of delay circuit D_{A1}. This logic 1 signal passes through delay circuits D_{A1} and D_{A2} to appear at terminal RoutA after a time determined by the combined delays of delay circuits D_{A1} and D_{A2}. This logic 1 is also fed to inverter I_{A1} which, because it is an inverter circuit, provides in response a logic 0 at its output, i.e. at a second input in2 of delay circuit D_{A1}. Hence, at time t₁ the output from FIFO element A goes high, as shown by waveform A in Figure 3.

FIFO elements B, C and D shown in figure 2 operate in a similar manner to FIFO element A and hence, the data signal logic 1 at terminal RoutA will pass via delay circuits D_{B1} and D_{B2} to terminal RoutB and to inverter I_{B1}.

In the meantime, although a logic 0 data signal has appeared on request input RiA, the output from FIFO element A will not go low until the output AoutB from FIFO element B has been passed back to delay circuit D_{A2} of element A via terminal AinA. This occurs when the output of delay circuit D_{B1} goes high and hence the output of inverter I_{A2}, and therefore the output of delay circuit D_{A2} goes low. This is shown at time t₃ in figure 3.

This effect ripples through the FIFO elements A,B,C and D and hence the output of FIFO element C goes high at time t₄, which causes the output of FIFO element B to go low at time t₅; an so on for FIFO elements C and D, as shown in Figure 3.

Figure 4 shows four FIFO elements connected as an asynchronous ring FIFO circuit 20 and it will be appreciated that because the FIFO circuits are connected in a ring, the effect of any one of the circuits going high and causing the preceding circuit in the ring to go low will ripple through the ring. Hence, the ring FIFO will exhibit a natural frequency of oscillation having a period determined predominantly by the delay circuits of the FIFOs coupled in the ring. With the present invention it has been realised that this frequency of oscillation is very sensitive to capacitance variation as such variation changes the delay provided by the delay circuits of the ring.

Figure 4 shows an electrode E1 coupled to a node between two of the FIFO elements of the ring FIFO 20. Hence, if a material such as a DNA sample is placed in contact with the electrode E1, any match between the sequence of the DNA strands of the DNA sample and the sequence of a DNA strand preconditioned onto the electrode will cause a change in the capacitance between the electrode E1 and a counter electrode E2. In essence, therefore, the electrodes E1 and E2 form the plates of a capacitor C and the DNA strands form a dielectric between the plates of the capacitor. The change in capacitance is dependent upon the area of the electrodes E1 and E2 but, typically, for an electrode having an area of 100 microns square, a match between DNA strands give rise to change in the capacitance value of capacitor C of about 0.07 picrofarad but, because the oscillation frequency of the FIFO ring circuit has been found to be very sensitive to small changes in the capacitance value of the ring, even such a very small change in the capacitance value of capacitor C is sufficient to cause a detectable change in the oscillation frequency of the ring FIFO.

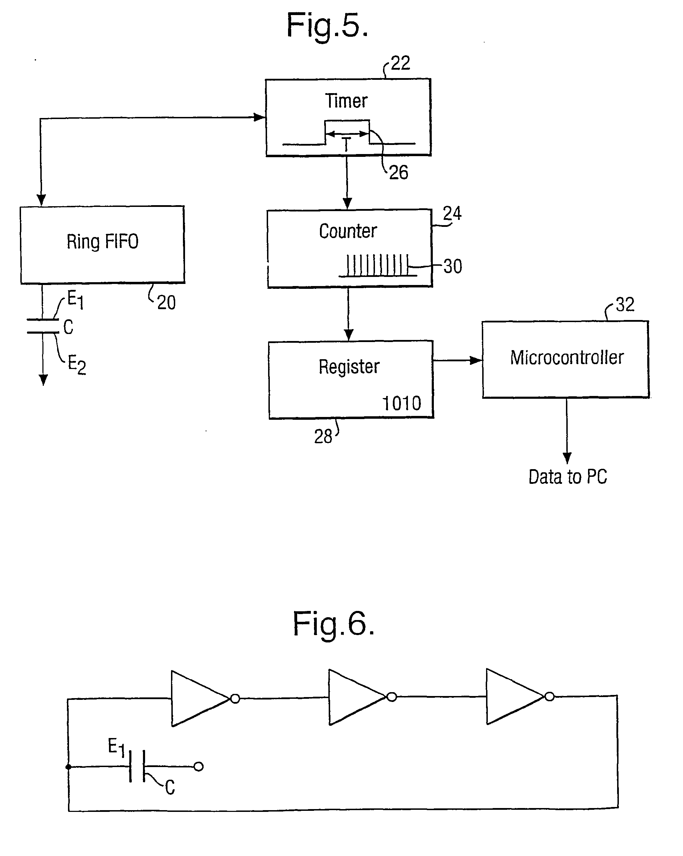

A practical configuration of a capacitance sensor incorporating an asynchronous ring FIFO oscillator circuit is shown in Figure 5.

The ring FIFO 20 has a node coupled to the electrode E1 for receiving a sample to be tested, which, in combination with the electrode E2 provides capacitor C, the capacitance value of which determines, in combination with the delay circuits of the FIFO elements the oscillation frequency of the ring FIFO 20. The biosensor includes a timer 22 coupled to a counter 24 which is connected to the output of ring FIFO circuit 20. The counter 24 counts the oscillation cycles of the ring FIFO during a count period determined by a clock signal 26 received from the timer 22. The counter 24 is coupled to a register block 28 which stores a count number 30 provided by the counter. The register block 28 is coupled to a microcontroller 32 which processes the count numbers stored in the register block to provide a data output which can identify the sample placed into contact with the electrode E1.

In operation, the capacitance sensor shown in figure 5 is first normalised by counting the oscillations cycles in a set time period T as determined by the clock pulse 26 of the timer circuit 22. This is referred to as a "nomalisation phase". Because the ring FIFO 20 operates as an asynchronous ring oscillator circuit, the frequency of oscillation will be determined only by the components making up the circuit elements of the FIFO ring and not by an external synchronous clock pulse. The time period T is chosen so that the count is completed as fast as possible and this normalisation phase enables any process variation to be tracked over time. As a result, the counter 24 provides therefore a first count value 30 which is stored in the register block 28. The sample under test, such as a DNA sample or an area of a fingertip of a human finger, is then placed into contact with the electrode E₁. This can be referred to as the measuring phase for the capacitance sensor. The sample causes a change in the capacitance value of capacitor C, which in turn causes a change in the oscillation frequency of the asynchronous ring FIFO. circuit 20. The counter 24 again counts the oscillation of the ring FIFO circuit 20 during the time period T to generate a second count value 30 which is also stored in the register block 28. The microcontroller 32 then compares the first and second count values and the difference is a quantitive measure indicative of the sample on the electrode E₁. The microcontroller 32 may contain look-up tables and the difference between the first and second count values is compared in sequence with values stored in the look-up tables to provide the quantitive measure. Such a process would be apparent to a person skilled in this art and will not therefore be described further in the context of the present invention.

The ring FIFO circuit 20, timer 22, counter 24, register block 28 and microcontroller 32 may all be provided on a single chip as an integrated circuit, with data output in a suitable format for connection directly to a personal computer. The microcontroller 32 may include the look-up tables with which the difference value is compared or, alternatively, the microcontroller 32 may be used only to provide the difference value, which is fed to the personal computer in which the look-up tables are stored.

In the embodiment shown in figure 5, the oscillation cycles are counted in a set time period T. However, the time period T may, alternatively, be selected either by providing data values which determine the time period T which are stored in the register block 28 or which are loaded into the register block for a particular capacitance sensing operation. In either case, the data values may be read in to the timer 26 from the register block 28 to set the count period T.

It is known that semiconductor circuits such as integrated circuits contain inherent capacitance, such as the SiO capacitance present in MOS devices. Hence, the number of FIFO elements in the asynchronous ring should preferably be maintained as small as possible so as to minimise the inherent capacitance in the ring, thereby increasing the sensitivity of the ring circuit to changes in the capacitance value of the capacitor C. This also provides generally a more controlled and stable environment for the capacitance sensor. The use of just two FIFO elements (each as shown in Figure 2) to provide the asynchronous ring FIFO has been found to be beneficial, which provides a relatively high frequency of oscillation of the ring because fewer delay circuits are present in the ring. This in turn enables the period T during which the oscillations of the ring are counted also to be minimised, providing efficient operation of the capacitance sensor.

To enable operation of the asynchronous ring FIFO circuit, at least one of the FIFO elements is required to be preset with a data logic 1 signal on its request input Rin. However, the asynchronous ring FIFO oscillator may be provided with more than one preset FIFO element, such as the two preset elements shown as Cp in figure 4.

It is also possible to further improve the accuracy of the capacitance sensor by using an averaging technique during the normalisation phase and/or the measuring phase. In this case, the first and/or second values are recorded over a number of the time periods T and these are then averaged to provide an average first and/or second count value or values, which are then compared to provide the difference value which in turn is compared with the look-up table.

The FIFO ring oscillator capacitance sensor described with reference to figures 1 to 5, is considered to provide a particularly advantageous capacitance sensor. The use of the FIFO circuits enables a reliable sensor to be achieved even when the circuit elements are implemented using thin film transistors (TFTs). As stated above, the use of TFTs is of particular benefit in sensors which, because of their intended application, are preferably readily disposable after use as a result of the plastics or other disposable materials that may be selected for use as the substrate material. Furthermore, the TFTs, as well as the circuit interconnects and insulator regions, can be fabricated using organic materials, which are also more easily disposed of in comparison to the more environmentally impacting materials used to fabricate CMOS silicon crystal type devices.

Moreover, because one of the delay elements of each FIFO circuit is held in its current condition until the output of the FIFO delay element following becomes valid, the arrangement provides a circuit which is very stable in operation. This is in spite of the fact that the FIFO circuits can each include an inverter circuit fabricated from TFTs on one input of each delay element. It is pointed out that it is well known to persons skilled in this art that inverter circuits with consistent timing characteristics are particularly difficult to fabricate with TFTs because the characteristics of the p and the n channel TFT devices vary considerably. Hence, TFTs are, in practice, not usually used to fabricate inverter circuits. Furthermore, the use of the FIFO circuits gives rise to an additional benefit in that runt pulses, which can be found in inverter circuit type ring oscillators, particularly those with greater than the minimum number of inverters in the ring, are not found to be generated.

Additionally, the oscillation frequency of the ring oscillator is known to be proportional to two principal factors. Firstly, the frequency is proportional to the delay of each inverter, so to maximise the change in oscillation frequency it is highly desirable to minimise the inherent circuit delays. This in turn means that the circuit ring should be implemented using the minimum number of stages. Secondly, the oscillation frequency is dependent upon the delay in charging the capacitor formed by the sensing electrode. When the sensor is fabricated using FIFO circuit elements, it has been found that reliable operation can be provided using only two FIFO circuits because the necessary buffering can be placed within the FIFO elements. In contrast, other design configurations are forced to use a relatively large total ring delay, and hence a comparatively increased number of stages (with the resultant loss of sensitivity) to continue to ensure fast rising and falling signal edges, similar to those provided by a. ring. FIFO circuit, which provide accurate and consistent timing.

In summary, therefore, surprising and significant benefits have been found to accrue through the use of FIFO circuit elements for the capacitance sensor.

Figure 6 shows an alternative configuration for the asynchronous ring oscillator circuit in the form of a plurality of inverter circuits 40, 42 and 44 connected in a ring with an electrode E1 forming one plate of a capacitor C coupled to the ring in a similar manner to the ring FIFO circuit shown in Figure 4. In the circuit shown in Figure 6, three inverter circuits are shown but, in practice, a larger number of such circuits would be used to ensure that the capacitor C is fully charged before the completion of a cycle of the ring inverter circuits; i.e. that the first inverter on the ring has not been reset by the last inverter on the ring before the capacitor C is fully charged.

In operation, assuming that a logic 0 is present on the input of inverter circuit 40. The output of inverter circuit 40 would therefore be logic 1, which is input to inverter circuit 42. The output of inverter circuit 42 is therefore logic 0, which is input to inverter circuit 44. The output of inverter circuit 44 is therefore logic 1 which is input to inverter circuit 40. Hence, it can be seen that any input or output of the inverter circuits will oscillate between logic 0 and logic 1, the frequency of operation being determined by the combined delay times of inverter circuits 40, 42 and 44. If the capacitor C is coupled to a node between any of the inverter circuits, the capacitor C introduces a further delay into the circuit which is dependent upon the capacitance value of the capacitor C. In this respect therefore the circuit shown in Figure 6 operates in a similar manner to the asynchronous ring FIFO circuit illustrated in Figure 4.

Preferably, the capacitance sensor according to the present invention is fabricated using polycrystalline TFTs as these lend themselves readily to very large scale integration as any suitable insulating substrate, such as soda glass or plastic, may be used. Furthermore, because the transistors can be fabricated on an insulating substrate rather than on a semiconductor substrate (which is necessary for single crystal semiconductor devices such as NMOS transistors) the bulk capacitance of the transistor devices is reduced in comparison to MOS transistors. This is a particularly desirable feature for a capacitance sensor as the intrinsic capacitance of the circuit is reduced, increasing the sensitivity of the sensor to capacitance changes arising at the electrode.

However, TFTs are known to have widely varying threshold voltages, even when manufactured in the same batch and using the same polysilicon film. Other parameter variations are also known to exist with these devices. The threshold voltage is effectively the voltage which must be applied to the gate electrode of the device for current to flow through the channel region of the TFT and so determines the ON-state of the TFT. This in turn dictates the time at which any TFT of the circuit will operate. This threshold voltage variation in TFTs is not problematical in the capacitance sensor of the present invention because an asynchronous ring oscillator circuit is adopted and the oscillation count is normalised each time prior to an actual sample measurement. Hence, the mode of operation automatically compensates for any variation in the frequency of oscillation arising from the parameter variations in the TFTs.

Additionally, when the capacitance sensor of the present invention is used as a bionsensor, the use of TFTs improves the disposability of the biosensor after test use and enables a larger size substrate to be used in comparison to single crystal MOS devices. Hence, the biosensor can be made as a large array of asynchronous oscillator circuits, each having an electrode for receiving a sample under test, and at reduced cost. Therefore, all of the biosensor circuit elements can be integrated onto a single substrate enabling a large number of samples to be tested either simultaneously or sequentially either by way of a number of asynchronous ring oscillators sharing common timing, counting, register and microcontroller circuits or by providing dedicated signal processing circuits for each asynchronous oscillator.

The aforegoing description has been given by way of example only and it will be appreciated by a person skilled in the art that modifications can be made without departing from the scope of the present invention.

For example, as referred to above in relation to figure 4, the change in capacitance at the electrode is proportional to electrode area and typically is about 0.07 picrofarad for an electrode of about 100 microns square. The sensitivity of the sensor can be enhanced by having more than one electrode (and therefore capacitor) in each asynchronous ring oscillator circuit. Furthermore, in practice, the capacitance sensor is most likely to be configured as an array of such sensors, each comprising an asynchronous ring oscillator circuit with one or more associated electrodes. The array may be provided with appropriate switching means, which may also comprise TFTs, to selectively couple the electrodes of any ring oscillator circuit of the array to another of the ring oscillators of the array to improve sensitivity.

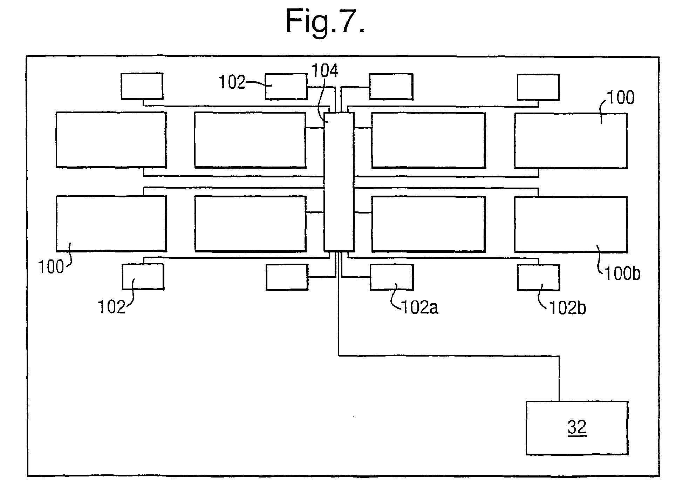

Figure 7 shows a capacitance sensor arranged as an array of eight sensors 100, each provided with a respective electrode 102. The capacitance sensor is also provided with a switching circuit 104 through which the sensors may be coupled to their respective electrodes 102. The switching circuit 104 can be arranged so that any of the electrodes 102 of the array can be coupled to any of the sensors 100. Hence, if a sample under test is known to provide a relatively small change in capacitance, the microcontroller 32, which is also coupled to the switching circuit 104, can be used to set pass gates within the switching circuit so as to connect more than one electrode of the array to one of the sensors 100, thereby to improve the sensitivity of the sensor because the sensor concerned is, in essence, thereby provided with a larger electrode area for receiving the sample under test. Therefore, for example, the switching circuit can be used to couple electrodes 102a and 102b to sensor 100b, thereby to improve the sensitivity of sensor 100b.

Moreover, although the capacitance sensor is described as comprising TFTs, these may be fabricated as organic semiconductor devices. Hence, the term TFT, in the context of the present invention, including the claims as appended hereto, includes both inorganic, e.g. polycrystalline, and organic, e.g. polymer thin film transistors, either alone or in combination.

Additionally, the electrodes may be fabricated from an inorganic material, e.g. metal, or a conductive organic material, such as a conductive polymer.

The use of organic thin film transistors and a conductive polymer material for the electrodes enables the capacitance sensor to be fabricated by a printing process, such as inkjet printing, which is particularly suited to very large scale integration and does not require the use of photolithographic or etch techniques.

## Claims

1. A capacitance sensor comprising a plurality of circuit elements arranged as an asynchronous ring oscillator circuit and an electrode coupled to a node between two of the circuit elements.

2. A capacitance sensor according to claim 1, wherein the circuit elements comprise inverter circuits.

3. A capacitance sensor according to claim 1, wherein the circuit elements comprise delay circuits and inverter circuits coupled so as to provide FIFO circuit elements.

4. A capacitance sensor according to any one of claims 1 to 3, comprising a counter circuit for counting the oscillations of the asynchronous ring oscillator circuit and a timer circuit for controlling a count period of the counter circuit.

5. A capacitance sensor according to claim 4, comprising a register circuit for storing the count of the count circuit.

6. A capacitance sensor according to claim 4 or 5, wherein the counter circuit is arranged to count the oscillations of the asynchronous ring oscillator circuit for each of a plurality of the count periods, and averaging means for determining an average of the oscillations counted during at least two of the count periods.

7. A capacitance sensor according to any one claims 4 to 6, wherein the count period is variable.

8. A capacitance sensor according to any one of the preceding claims wherein transistors of the capacitance sensor comprise exclusively thin film transistors.

9. A capacitance sensor according to any one of the preceding claims wherein the electrode comprises an organic conductive material.

10. A capacitance sensor comprising an array of capacitance sensors according to any one of the preceding claims and further comprising switching means for selectively coupling an electrode of one of the capacitance sensors of the array to another of the capacitance sensors of the array.

11. A capacitance sensor according to claim 10, wherein the switching means comprises a thin film transistor circuit.

12. A DNA sensor or a fingerprint sensor comprising a capacitance sensor according to any one of the preceding claims.

13. A capacitance sensing method comprising providing a sensor including a plurality of circuit elements arranged as an asynchronous ring oscillator circuit and sensing capacitance at an electrode coupled to a node between two of the circuit elements by sensing a change in the frequency of oscillation of the asynchronous ring oscillator circuit.

14. A capacitance sensing method according to claim 13, comprising providing a plurality of inverter circuits as the circuit elements.

15. A capacitance sensing method according to claim 13 comprising providing a plurality of delay elements and inverter circuits coupled so as to provide FIFO circuit elements.

16. A capacitance sensing method according to any one of claims 13 to 15 comprising counting oscillation cycles of the asynchronous oscillator circuit in a count period without a material to be identified in contact with the electrode to provide a first count value, counting the oscillations of the asynchronous ring oscillator circuit in the count period with the material to be identified in contact with the electrode to provide a second count value, and comparing the first and second count values.

17. A capacitance sensing method according to claim 16, comprising storing the first and/or second count values in a register circuit.

18. A capacitance sensing method according to claim 16 or 17, wherein the first and/or second counts are counted for each of a plurality of the count periods, and respectively averaging the first and/or the second counts counted during at least two of the count periods.

19. A capacitance sensing method according to any one of claims 16 to 18, comprising varying the count period.

20. A capacitance sensing method according to any one of claims 13 to 19, comprising providing the sensor so as to include transistors which are exclusively thin film transistors.

21. A capacitance sensing method according to any one of claims 13 to 20 comprising providing the electrode so as to comprise an organic conductive material.

22. A capacitance sensing method comprising providing an array of sensors according to any one of claims 13 to 21 and providing switching means arranged to selectively couple an electrode of a sensor of the array to another of the sensors of the array.

23. A capacitance sensing method according to claim 22 comprising providing the switching means as a thin film transistor circuit.

24. A capacitance sensing method according to any one of claims 13 to 23, comprising depositing a DNA sample onto the electrode.

25. A capacitance sensing method according to any one of claims 13 to 23, comprising depositing a human fingertip onto the electrode to effect fingerprint recognition.

26. A method of fabricating a capacitance sensor according to claim 8, or claim 9 when appendant to claim 8, or claim 11 when appendant to claim 10, when appendant to claim 8 or 9, comprising an ink jet printing technique.

## Patentansprüche

1. Kapazitätssensor, umfassend eine Mehrzahl von Schaltelementen, die als asynchrone Ringoszillatorschaltung angeordnet sind, und eine Elektrode, die an einen Knoten zwischen zwei der Schaltelemente gekoppelt ist.

2. Kapazitätssensor nach Anspruch 1, wobei die Schaltelemente Inverterschaltungen umfassen.

3. Kapazitätssensor nach Anspruch 1, wobei die Schaltelemente Verzögerungsschaltungen und Inverterschaltungen umfassen, die so gekoppelt sind, dass FIFO-Schaltelemente bereitgestellt werden.

4. Kapazitätssensor nach einem der Ansprüche 1 bis 3, umfassend eine Zählerschaltung zum Zählen der Oszillationen der asynchronen Ringoszillatorschaltung, und eine Zeitgeberschaltung zum Steuern einer Zählperiode der Zählerschaltung.

5. Kapazitätssensor nach Anspruch 4, umfassend eine Registerschaltung zum Speichern der Zählung der Zählerschaltung.

6. Kapazitätssensor nach Anspruch 4 oder 5, wobei die Zählerschaltung so angeordnet ist, dass sie die Oszillationen der asynchronen Ringoszillatorschaltung für jede einer Mehrzahl von Zählperioden zählt, und mit einem Durchschnittsbildungsmittel zum Bestimmen eines Durchschnitts der Oszillationen, die während mindestens zwei der Zählperioden gezählt wurden.

7. Kapazitätssensor nach einem der Ansprüche 4 bis 6, wobei die Zählperiode variabel ist.

8. Kapazitätssensor nach einem der vorangehenden Ansprüche, wobei Transistoren des Kapazitätssensors ausschließlich Dünnfilmtransistoren umfassen.

9. Kapazitätssensor nach einem der vorangehenden Ansprüche, wobei die Elektrode ein organisches leitendes Material umfasst.

10. Kapazitätssensor, umfassend eine Gruppe von Kapazitätssensoren nach einem der vorangehenden Ansprüche, und des Weiteren umfassend Schaltmittel zum selektiven Koppeln einer Elektrode eines der Kapazitätssensoren der Gruppe an einen anderen der Kapazitätssensoren der Gruppe.

11. Kapazitätssensor nach Anspruch 10, wobei das Schaltmittel eine Dünnfilmtransistorschaltung umfasst.

12. DNA-Sensor oder Fingerabdrucksensor, umfassend einen Kapazitätssensor nach einem der vorangehenden Ansprüche.

13. Kapazitätserfassungsmethode, umfassend das Bereitstellen eines Sensors, der eine Mehrzahl von Schaltelementen enthält, die als asynchrone Ringoszillatorschaltung angeordnet sind, und die Kapazität an einer Elektrode erfasst, die an einen Knoten zwischen zwei der Schaltelemente gekoppelt ist, indem eine Änderung in der Frequenz der Oszillation der asynchronen Ringoszillatorschaltung erfasst wird.

14. Kapazitätserfassungsmethode nach Anspruch 13, umfassend das Bereitstellen einer Mehrzahl von Inverterschaltungen als Schaltelemente.

15. Kapazitätserfassungsmethode nach Anspruch 13, umfassend das Bereitstellen einer Mehrzahl von Verzögerungselementen und Inverterschaltungen, die so gekoppelt sind, dass FIFO-Schaltelemente bereitgestellt werden.

16. Kapazitätserfassungsmethode nach einem der Ansprüche 13 bis 15, umfassend das Zählen von Oszillationszyklen der asynchronen Ringoszillatorschaltung in einer Zählperiode, in der kein zu identifizierendes Material mit der Elektrode in Kontakt steht, um einen ersten Zählwert zu erhalten, das Zählen der Oszillationen der asynchronen Ringoszillatorschaltung in der Zählperiode, in der das zu identifizierende Material mit der Elektrode in Kontakt steht, um einen zweiten Zählwert zu erhalten, und das Vergleichen der ersten und zweiten Zählwerte.

17. Kapazitätserfassungsmethode nach Anspruch 16, umfassend das Speichern der ersten und/oder zweiten Zählwerte in einer Registerschaltung.

18. Kapazitätserfassungsmethode nach Anspruch 16 oder 17, wobei die ersten und/oder zweiten Zählungen für jede einer Mehrzahl der Zählperioden gezählt werden, und jeweils der Durchschnitt der ersten und/oder der zweiten Zählungen, die während mindestens zwei der Zählperioden gezählt wurden, ermittelt wird.

19. Kapazitätserfassungsmethode nach einem der Ansprüche 16 bis 18, umfassend das Variieren der Zählperiode.

20. Kapazitätserfassungsmethode nach einem der Ansprüche 13 bis 19, umfassend das Bereitstellen des Sensors in derartiger Weise, dass er Transistoren enthält, die ausschließlich Dünnfilmtransistoren sind.

21. Kapazitätserfassungsmethode nach einem der Ansprüche 13 bis 20, umfassend das Bereitstellen der Elektrode in derartiger Weise, dass sie ein organisches leitendes Material umfasst.

22. Kapazitätserfassungsmethode, umfassend das Bereitstellen einer Gruppe von Sensoren nach einem der Ansprüche 13 bis 21, und das Bereitstellen von Schaltmitteln, die so angeordnet sind, dass sie eine Elektrode eines Sensors der Gruppe selektiv an einen anderen der Sensoren der Gruppe koppeln.

23. Kapazitätserfassungsmethode nach Anspruch 22, umfassend das Bereitstellen des Schaltmittels als Dünnfilmtransistorschaltung.

24. Kapazitätserfassungsmethode nach einem der Ansprüche 13 bis 23, umfassend das Auflegen einer DNA-Probe auf die Elektrode.

25. Kapazitätserfassungsmethode nach einem der Ansprüche 13 bis 23, umfassend das Auflegen einer menschlichen Fingerspitze auf die Elektrode, um eine Fingerabdruckerkennung zu erreichen.

26. Verfahren zur Herstellung eines Kapazitätssensors nach Anspruch 8 oder Anspruch 9, wenn dieser von Anspruch 8 abhängig ist, oder Anspruch 11, wenn dieser von Anspruch 10 abhängig ist, wenn dieser von Anspruch 8 oder 9 abhängig ist, umfassend eine Tintenstrahldrucktechnik.

## Revendications

1. Capteur capacitif comportant une pluralité d'éléments de circuit disposés sous la forme d'un circuit oscillateur annulaire asynchrone et une électrode couplée à un noeud entre deux des éléments de circuit.

2. Capteur capacitif selon la revendication 1, dans lequel les éléments de circuit comportent des circuits inverseurs.

3. Capteur capacitif selon la revendication 1, dans lequel les éléments de circuit comportent des circuits de temporisation et des circuits inverseurs couplés de manière à fournir des éléments de circuit FIFO.

4. Capteur capacitif selon l'une quelconque des revendications 1 à 3, comportant un circuit compteur pour compter les oscillations du circuit oscillateur annulaire asynchrone et un circuit des temporisation pour commander une période de comptage du circuit compteur.

5. Capteur capacitif selon la revendication 4, comportant un circuit de registre pour enregistrer le comptage du circuit compteur.

6. Capteur capacitif selon les revendications 4 ou 5, dans lequel le circuit compteur est conçu pour compter les oscillations du circuit oscillateur à anneau asynchrone pour chacune d'une pluralité des périodes de comptage, et des moyens pour déterminer une moyenne des oscillations comptées durant au moins deux des périodes de comptage.

7. Capteur capacitif selon l'une quelconque des revendications 4 à 6, dans lequel la période de comptage est variable.

8. Capteur capacitif selon l'une quelconque des revendications précédentes, dans lequel les transistors du capteur capacitif sont exclusivement constitués de transistors à couche mince.

9. Capteur capacitif selon l'une quelconque des revendications précédentes, dans lequel l'électrode comporte un matériau organique conducteur.

10. Capteur capacitif comportant une matrice de capteurs capacitifs selon l'une quelconque des revendications précédentes et comportant en outre des moyens de commutation pour le couplage sélectif d'une électrode de l'un des capteurs capacitifs de la matrice à l'un des autres capteurs capacitifs de la matrice.

11. Capteur capacitif selon la revendication 10, dans lequel le moyen de commutation comporte un circuit de transistors à couche mince.

12. Capteur ADN ou capteur d'empreinte digitale comportant un capteur capacitif selon l'une quelconque des revendications précédentes.

13. Méthode de détection capacitive comprenant la fourniture d'un capteur comportant une pluralité d'éléments de circuit disposés sous la forme d'un circuit oscillateur annulaire asynchrone et une capacité de détection au niveau d'une électrode couplée à un noeud entre deux des éléments de circuit, par la détection d'un changement au niveau de la fréquence d'oscillation du circuit oscillateur annulaire asynchrone.

14. Méthode de détection capacitive selon la revendication 13, comprenant la fourniture d'une pluralité de circuits inverseurs en tant qu'éléments de circuit.

15. Méthode de détection capacitive selon la revendication 13, comprenant la fourniture d'une pluralité d'éléments de temporisation et de circuits inverseurs couplés de manière à fournir des éléments de circuit FIFO.

16. Méthode de détection capacitive selon l'une quelconque des revendications 13 à 15 comprenant le comptage des cycles d'oscillation du circuit oscillateur annulaire asynchrone sur une période de comptage sans qu'il y ait .de matériau à identifier en contact avec l'électrode afin de fournir une première valeur de comptage; le comptage des oscillations du circuit oscillateur annulaire asynchrone sur la période de comptage avec le matériau à identifier en contact avec l'électrode afin de fournir une seconde valeur de comptage, et la comparaison des deux valeurs de comptage.

17. Méthode de détection capacitive selon la revendication 16, comprenant l'enregistrement de la première et/ou de la seconde valeur de comptage dans un circuit de registre.

18. Méthode de détection capacitive selon la revendication 16 ou 17, dans laquelle les premiers et/ou les seconds comptages sont effectués pour chacune d'une pluralité des périodes de comptage, et la moyenne respective des premiers et/ou des seconds comptages effectués durant au moins deux des périodes de comptage est calculée.

19. Méthode de détection capacitive selon l'une quelconque des revendications 16 à 18, comprenant la variation de la période de comptage.

20. Méthode de détection capacitive selon l'une quelconque des revendications 13 à 19, comprenant la fourniture du capteur de manière à inclure des transistors exclusivement constitués de transistors à couche mince.

21. Méthode de détection capacitive selon l'une quelconque des revendications 13 à 20, comprenant la fourniture de l'électrode telle que celle-ci inclut un matériau organique conducteur.

22. Méthode de détection capacitive comprenant la fourniture d'une matrice de capteurs selon l'une quelconque des revendications 13 à 21 et la fourniture de moyens de commutation conçus pour le couplage sélectif d'une électrode d'un capteur de la matrice à un des autres capteurs de la matrice.

23. Méthode de détection capacitive selon la revendication 22 comprenant la fourniture de moyens de commutation sous la forme d'un circuit de transistors à couche mince.

24. Méthode de détection capacitive selon l'une quelconque des revendications 13 à 23, comprenant le dépôt d'un échantillon d'ADN sur l'électrode.

25. Méthode de détection capacitive selon l'une quelconque des revendications 13 à 23, comprenant l'application du bout d'un doigt humain sur l'électrode pour effectuer la reconnaissance d'empreintes digitales.

26. Méthode de fabrication d'un capteur capacitif selon la revendication 8, ou la revendication 9 lorsqu'elle est rattachée à la revendication 8, ou la revendication 11 lorsqu'elle est rattachée à la revendication 10, lorsque celle-ci est rattachée à la revendication 8 ou 9, comprenant une technique d'impression par jet d'encre.
